(19) Europäisches Patentamt / European Patent Office / Office européen des brevets

(11) EP 4 139 370 B1

(12) **EUROPEAN PATENT SPECIFICATION**

(45) Date of publication and mention of the grant of the patent:
**17.12.2025 Bulletin 2025/51**

(21) Application number: **21717905.0**

(22) Date of filing: **14.04.2021**

(51) International Patent Classification (IPC):
***C08F 14/22*** *(2006.01)* ***C08F 214/22*** *(2006.01)*
***C08J 5/18*** *(2006.01)*

(52) Cooperative Patent Classification (CPC):
(C-Sets available)
**C08F 214/22; C08F 14/22; C08J 5/18;**
C08F 14/185; C08F 214/182; C08J 2327/16
(Cont.)

(86) International application number:
**PCT/EP2021/059704**

(87) International publication number:
**WO 2021/213868 (28.10.2021 Gazette 2021/43)**

(54) **AQUEOUS DISPERSION OF VINYLIDENE FLUORIDE AND TRIFLUOROETHYLENE CONTAINING POLYMERS**

WÄSSRIGE DISPERSION VON VINYLIDENFLUORID- UND TRIFLUORETHYLENHALTIGEN POLYMEREN

DISPERSION AQUEUSE DE POLYMÈRES CONTENANT DU FLUORURE DE VINYLIDÈNE ET DU TRIFLUOROÉTHYLÈNE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.04.2020 EP 20170585**

(43) Date of publication of application:
**01.03.2023 Bulletin 2023/09**

(73) Proprietor: **Syensqo Specialty Polymers Italy S.p.A.**
**20021 Bollate (MI) (IT)**

(72) Inventors:
- **MARRANI, Alessio**
  **23900 LECCO LC (IT)**
- **FALCO, Ivan**
  **20008 Bareggio MI (IT)**
- **MILLEFANTI, Stefano**
  **21049 Tradate VA (IT)**

(74) Representative: **Briatore, Andrea**
**Syensqo S.A.**
**Viale Lombardia, 20**
**20021 Bollate (MI) (IT)**

(56) References cited:
**EP-A1- 0 508 802**
**WO-A1-2008/041998**
**WO-A1-2018/065306**
**JP-A- 2008 297 528**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08F 14/22, C08F 2/22;**
C08F 14/185, C08F 2/22

## Description

Technical Field

The invention pertains to copolymers of vinylidene fluoride and trifluoroethylene having improved electric properties, to a process for their manufacture in aqueous medium in the absence of fluorinated surfactants, and to their use as piezoelectric, ferroelectric, dielectric or pyroelectric materials in electric/electronic devices.

Background Art

It is well known that copolymers of vinylidene fluoride and trifluoroethylene are employed and are being developed for use in electric/electronic devices (e.g. transducers, sensors, actuators, ferroelectric memories, capacitors) because of their ferroelectric, piezoelectric, pyroelectric and dielectric behaviour/properties, piezoelectric behaviour being particularly used.

As is well known, the term piezoelectric means the ability of a material to exchange electrical for mechanical energy and vice versa. The electromechanical response is believed to be essentially associated with dimensional changes during deformation or pressure oscillation. The piezoelectric effect is reversible in that materials exhibiting the direct piezoelectric effect (the production of electricity when stress is applied) also exhibit the converse piezoelectric effect (the production of stress and/or strain when an electric field is applied).

Ferroelectricity is the property of a material whereby this latter exhibits a spontaneous electric polarization, the direction of which can be switched between equivalent states by the application of an external electric field

Pyroelectricity is the ability of certain materials to generate an electrical potential upon heating or cooling. Actually, as a result of this change in temperature, positive and negative charges move to opposite ends through migration (i.e. the material becomes polarized) and hence, an electrical potential is established.

It is generally understood that piezo-, pyro-, ferro-electricity in copolymers of vinylidene fluoride and trifluoroethylene is related to a particular crystalline habit, so called ferroelectric-phase or beta-phase, wherein hydrogen and fluorine atoms are arranged to give maximum dipole moment per unit cell.

Said VDF-TrFE copolymers are well known in the art and are notably described in US 4778867 (PRIES SEYMOUR (US) ) 18/10/1988 , US 4708989 (THOMSON CSF (FR)) 24/11/1987 , US 4784915 (KUREHA CHEMICAL IND CO LTD (JP)) 15/11/1988 , US 4173033 (DAIKIN IND LTD (JP)) 30/10/1979 .

Generally speaking, techniques for manufacturing these VDF-TrFE copolymers may be based on suspension polymerization, i.e. in conditions of temperature and pressure such that VDF is present in supercritical phase, using organic initiators in aqueous phase, and producing a slurry of coarse particles which precipitate from aqueous polymerization medium as soon as produced. Nevertheless, suspension polymerization technologies are quite burdensome to handle at industrial level, because of the high pressures employed, and because of the safety concerns hence associated to the handling in such harsh conditions of TrFE, possibly undergoing explosive behaviour. As TrFE has been recognized to be endowed with deflagration/explosion behaviour similar to tetrafluoroethylene (TFE), opportunity of limiting polymerization pressure represents a significant advantage in safety management.

Hence, techniques based on aqueous-based emulsion polymerization have been explored, as they enable producing in more mild conditions, yet at high throughput rate, stable dispersions of VDF-TrFE polymer particles, with less environmental concerns, at limited trifluoroethylene (TrFE) partial pressure and overall pressure.

Moreover, access to latexes or more in general to aqueous dispersions of VDF-TrFE polymer enables opening processing/transformation opportunities to coating/casting techniques based on solvent-free approaches, which are attracting more and more attention in this area.

However, VDF-TrFE copolymers obtained from latexes produced by aqueous emulsion polymerization processes of the prior art require the use of a fluorinated surfactant, which is undesirable ingredient from an environmental standpoint.

Another problem related to VDF-TrFE copolymers obtained from latexes produced by aqueous emulsion polymerization processes of the prior art is that they have in general less valuable piezo-, pyro-, ferro-electric performances, when compared to e.g. suspension-polymerized VDF-TrFE copolymers.

Now, optimization of piezoelectric, pyroelectric or ferroelectric effect requires thermodynamic order of the ferroelectric phase to be maximized, so as to have more structured crystalline domain delivering improved piezo-, pyro-, ferro-electric performances, which is in conflict with the results obtained through emulsion polymerization.

WO 2018/065306 to Solvay Specialty proposes a solution to this second problem describing an emulsion polymerization method for making a latex of a copolymer of VDF, TrFE and optionally other comonomers, wherein the polymer has a thermodynamic ordered structure in the ferroelectric phase, such that the relation between

(i) the parameter Xc (%)defined as follows: $$Xc\ (\%) = \frac{\Delta H_c}{(\Delta H_m + \Delta H_c)} \times 100$$ wherein $\Delta H_c$ is the enthalpy associated to the Curie transition between ferroelectric and paraeletric phase, as determined in J/g by DSC technique on second heating scan, at a ramp rate of 10°C, and $\Delta H_m$ is the enthalpy of melting, as determined in J/g according to ASTM D3418; and

(ii) the content in recurring units different from VDF expressed in % moles, with respect to the total moles of recurring units, designated as CM (% moles), satisfies the following inequality:

$$Xc\ (\%) \geq a \cdot CM\ \ (\%moles) + b$$

wherein a = -1.10 and b =75.00.

The Xc parameter described above is related to the thermodynamic order of the ferroelectric phase, and polymers obtained with this method have a particularly high thermodynamic order of the ferroelectric phase which correlates with improved electrical properties. However the method described in WO 2018/065306 still requires the use of a fluorinated surfactant complying with formula (I):

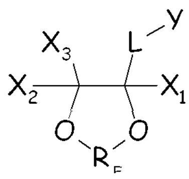

(I)

wherein $X_1$, $X_2$, $X_3$, equal or different from each other are independently selected among H, F, and $C_{1-6}$(per)fluoroalkyl groups, optionally comprising one or more catenary or non-catenary oxygen atoms; L represents a bond or a divalent group; $R_F$ is a divalent fluorinated $C_{1-3}$ bridging group; Y is an anionic functionality.

There is thus still a need in the art for aqueous dispersions of copolymers comprising VDF and TrFE recurring units, which can be manufactured in aqueous medium free from fluorinated surfactants, in smooth conditions comparable to those of the prior art emulsion polymerization, and which polymer has a high thermodynamic order in the ferroelectric phase and consequently electrical properties in line or improved with respect to the polymers of the prior art.

Now, the invention described herein provides a method that satisfies these needs.

Summary of invention

The invention pertains to a method for making an aqueous dispersion comprising particles of a polymer (polymer F) said polymer F comprising:

- recurring units derived from vinylidene fluoride (VDF) in an amount of from 60% to 82% in moles, with respect to the total moles of recurring units
- recurring units derived from trifluoroethylene (TrFE) in an amount of from 18% to 40% in moles, with respect to the total moles of recurring units, and
- optionally recurring units derived from at least one additional monomer different from VDF and TrFE,
- said particles having a number average particle size measured using laser scattering in accordance with ISO 13321 is comprised from 200 - 5000 nm,

said polymer (F) possessing thermodynamic ordered structure in the ferroelectric phase, such that the relation between:

(i) the parameter Xc (%)defined as follows:

$$Xc\ (\%) = \frac{\Delta H_c}{(\Delta H_m + \Delta H_c)} \times 100$$

wherein $\Delta H_c$ is the enthalpy associated to the Curie transition between ferroelectric and paraeletric phase, as determined in J/g by DSC technique on second heating scan, at a ramp rate of 10°C, and $\Delta H_m$ is the enthalpy of melting, as determined in J/g according to ASTM D3418; and

(ii) the content in recurring units of VDF expressed in % moles, with respect to the total moles of recurring units, designated as CM, satisfies the following inequality:

$$Xc(\%) > a_*(100\text{-}CM) + b$$

wherein a= -1,89, b=99.

Preferably Xc(%) > $a_*$(100-CM) + b wherein a= -1,89, b=100.

This inequality reflects a higher value for the parameter Xc for a given polymeric composition with respect to the dispersion of the prior art including those described in the mentioned patent application WO 2018/065306 cited above in the "Background of the Invention" section. As mentioned above with reference to the cited prior art document, this higher value of Xc corresponds to a higher thermodynamic order in the ferroelectric phase which translates into improved electrical properties as it will be shown in the experimental section.

The method for making an aqueous dispersion of polymer particles having the features described above comprises polymerizing 60% to 82% in moles based on the total moles of monomers of vinylidene fluoride (VDF), 18% to 40% in moles based on the total moles of monomers of trifluoroethylene (TrFE), and optionally at least one additional monomer different from VDF and TrFE in an aqueous reaction medium in the presence of a radical initiator selected from the group consisting of persulfates, wherein:

- the polymerization is conducted at a total pressure comprised between 25 and 35 bars (2.5 to 3.5 MPa) and a temperature comprised between 75°C and 95°C,
- the dispersion obtained has a solid content of 1 to 30% by weight,
- the aqueous reaction medium is free from fluorinated surfactants, preferably is free from added surfactants.

The Applicant has surprisingly found that the method as above detailed enables the manufacture in smooth conditions and high throughput, in particular at relatively lower TrFE partial pressure and total pressure, of aqueous dispersions of VDF-TrFE polymers, wherein said polymers possess improved structural/conformational order in their ferro-electric phase, as measured using the Xc (%) parameter, as defined above, and consequently improved piezo-, pyro-, ferro-electric performances, as well as improved electrical properties if compared with VDF-TrFE polymers of the prior art.

Brief description of drawings

Figure 1 represents the value of the parameter Xc(%) for samples obtained according to the invention and for comparative samples as a function of the percentage of VDF recurring units in the polymer.

Figure 1 is a plot of the parameter Xc (%), hereunder referred also as crystallinity order parameter, as a function of the VDF content in % moles. The data points indicated by A correspond to Examples 1-3 according to the invention. The data points indicated with ● correspond to the comparative examples CA1-CA3. The data points indicated with X correspond to the comparative examples CB1-CB3. The dotted line corresponds to Xc%=-1.89(100-CM) + 99 and the dashed line corresponds to Xc%=-1.89(100-CM) + 100.

Disclosure of Invention

As described above, the present invention relates to a method for making an aqueous dispersion comprising particles of a fluorinated polymer (F). The Polymer (F) obtained in accordance with the invention comprises from 60% to 82% by moles, preferably from 65% to 80%, more preferably from 68% to 80% of recurring units derived from VDF and from 18% to 40% by moles, preferably from 20 to 35 %, more preferably from 20% to 32% by moles of recurring units derived from TrFE. The percentages are based on the total number of recurring units.

The Polymer (F) obtained in accordance with the invention may further comprise recurring units derived from one

or more than one fluoromonomers other than VDF and TrFE, such as notably hexafluoropropylene, tetrafluoroethylene, chlorotrifluoroethylene, or recurring units derived from one or more than one non-fluorinated monomers, such as notably acrylic or methacrylic monomers, and more specifically, recurring units derived from at least one hydrophilic (meth)acrylic monomer (MA) of formula:

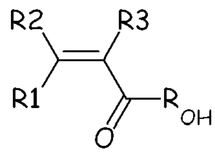

wherein each of R1, R2, R3, equal or different from each other, is independently an hydrogen atom or a $C_1$-$C_3$ hydrocarbon group, and $R_{OH}$ is a hydroxyl group or a $C_1$-$C_5$ hydrocarbon moiety comprising at least one hydroxyl group.

Non limitative examples of hydrophilic (meth)acrylic monomers (MA) are notably acrylic acid, methacrylic acid, hydroxyethyl (meth)acrylate, hydroxypropyl(meth)acrylate; hydroxyethylhexyl(meth)acrylates.

The monomer (MA) is more preferably selected among:

- hydroxyethylacrylate (HEA) of formula:

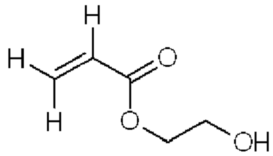

- 2-hydroxypropyl acrylate (HPA) of either of formulae:

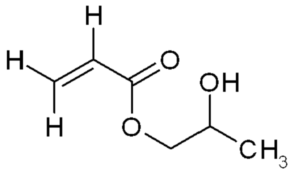

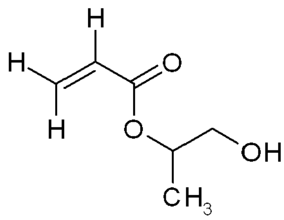

- acrylic acid (AA) of formula:

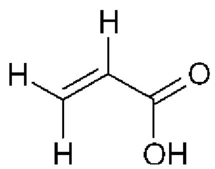

- and mixtures thereof.

When an additional comonomer different from VDF and TrFE is present, the Polymer (F) advantageously comprises:

- recurring units derived from vinylidene fluoride (VDF) in an amount of from 60 % to 82 % moles, with respect to the total moles of recurring units;
- recurring units derived from trifluoroethylene (TrFE) in an amount of from 18 % to 40 % moles, with respect to the total moles of recurring units, and
- recurring units derived from at least one additional monomer different from VDF and TrFE, in an amount of 0.1 to 5 % moles.

Nevertheless, polymers consisting essentially of recurring units derived from VDF and TrFE are generally preferred.

Melt flow index (MFI) of the polymer (F) will be selected by the skilled in the art in relation to the processing technology chosen for obtaining final parts (e.g. films or sheets).

It is nevertheless generally understood that polymer (F) will have a MFI determined according to ASTM D 1238 (230°C/ 5 kg) of advantageously 0.5 to 500 g/10 min, preferably of 0.5 to 200 g/10 min, more preferably of 0.5 to 10 g/10 min.

The aqueous dispersion obtained in accordance with the invention is preferably free from fluorinated surfactants, which are undesirable from the environmental standpoint, and even more preferably is free from any added surfactant.

As said, the aqueous dispersion of the invention comprises particles of polymer (F) possessing a parameter Xc (%), i.e. crystallinity order parameter, such to satisfy the aforementioned inequality.

From a technical standpoint, this crystallinity order parameter is a measure of the structural and conformational order of the ferroelectric phase, the higher the Xc parameter, the more structured and ordered being the ferroelectric crystalline phase.

As a consequence, polymer (F) from the aqueous dispersions obtained in accordance with the invention are such to possess improved ferroelectric performances, as derived from the ferroelectric crystalline phase, the higher the structural order, the better the ferroelectric performances, over polymers from latexes which may be manufactured using the techniques of the prior art.

The method for making an aqueous dispersion as above detailed comprises polymerizing 60% to 82% in moles based on the total moles of monomers of vinylidene fluoride (VDF), 18% to 40% in moles based on the total moles of monomers of trifluoroethylene (TrFE), and optionally at least one additional monomer different from VDF and TrFE in appropriate amounts so to obtain a polymer F as described in an aqueous reaction medium. The key parameters to be controlled in order for the reaction to proceed properly in the absence of fluorinated surfactants, and preferably in the absence of any other added surfactants, are the choice of initiator, the temperature, the total pressure and total concentration of polymer.

In fact, in order to provide a polymer F with a sufficiently high thermodynamic order of the ferroelectric phase it is essential to conduct the reaction in the presence of a persulfate radical initiator, preferably selected from sodium, potassium and ammonium persulfate, at a total pressure comprised between 25 and 35 bars (2.5 to 3.5 MPa), preferably between 27 and 32 bars (2.7 to 3.2 MPa), and a temperature comprised between 75 and 95°C, preferably between 82°C and 90°C Also the ratio between the amount of aqueous reaction medium and monomers must be such that the dispersion obtained has a solid content of from 1 to 30% by weight, preferably from 10 to 30%, more preferably from 15 to 30%.

The radical initiator is included in the aqueous reaction medium at a concentration ranging preferably from 0.001 to 20 percent by weight of the reaction medium.

Polymerization can be carried out in the presence of a chain transfer agent. The chain transfer agent is selected from those known in the polymerization of fluorinated monomers, such as for instance: ketones, esters, ethers or aliphatic alcohols having from 3 to 10 carbon atoms, such as acetone, ethylacetate, diethylether, methyl-ter-butyl ether, isopropyl alcohol, etc.; chloro(fluoro)carbons, optionally containing hydrogen, having from 1 to 6 carbon atoms, such as chloroform, trichlorofluoromethane; bis(alkyl)carbonates wherein the alkyl has from 1 to 5 carbon atoms, such as bis(ethyl)carbonate, bis(isobutyl)carbonate. The chain transfer agent can be fed to the polymerization medium at the beginning, continuously or in discrete amounts (step-wise) during the polymerization, continuous or stepwise feeding being preferred.

The described process leads to the formation of an aqueous dispersion of polymer (F), as described. The number average particle size of the particles of polymer F measured with laser scattering method in accordance with ISO 13321 is typically comprised from 200 to 5000 nm, preferably from 300 to 1000 nm. In general dispersions prepared with the method of the invention have a number average particle size slightly higher than the latexes of the prior art which require the use of a fluorinated surfactant. Such dispersions are generally stable, in some cases the dispersed particles may tend to settle, but can be redispersed with stirring as known to the skilled person. Once formed in the aqueous dispersion of the invention, the polymer F can be separated from the aqueous medium with known separation and or coagulation techniques applied to dispersions and latexes such as, for example freezing the dispersion and thawing it (thereby causing coagulation of the dispersed particles), and then separating mechanically the polymer, washing it with demineralized water and finally drying the polymer. Alternative methods such as filtration and centrifugation are known to the skilled person.

The invention also pertains to the use of polymer (F) as above described as ferroelectric, piezoelectric, dielectric or pyroelectric material in electric/electronic devices.

Non limitative examples of said devices are notably transducers, sensors, actuators, ferroelectric memories, capacitors.

The polymer (F) is generally comprised in said devices under the form of substantially bidimensional parts (e.g. films or sheets).

Said films or sheets can be manufactured according to standard techniques, as extrusion, injection moulding, compression moulding and solvent casting.

Said bidimensional articles can be further submitted to post-processing treatment, in particular for enhancing ferroelectric, piezoelectric, dielectric or pyroelectric behaviour, e.g. annealing, stretching and bi-orientation.

Bidimensional articles can be notably submitted to a high poling electric field obtained by polarization cycles for adjusting, in real time via high voltage and data acquisition computer controlled system, polarization, residual polarization and maximum displacement current measured at the coercive field. An embodiment of this process is described in ISNER-BROM, P., et al. Intrinsic Piezoelectric Characterization of PVDF copolymers: determination of elastic constants. Ferroelectrics. 1995, vol.171, p.271-279. , in BAUER, F., et al. Very high pressure behaviour of precisely-poled PVDF. Ferroelectrics. 1995, vol.171, p.95-102. and in US 4611260 (DEUTSCH FRANZ FORSCH INST (FR) ) 9/09/1986 and US 4684337 (DEUTSCH FRANZ FORSCH INST (FR) ) 4/08/1987.

The invention will be now explained in more detail with reference to the following examples, whose purpose is merely illustrative and not intended to limit the scope of the invention.

**Polymerization examples according to the invention**

In the following examples the polymerization pressure is expressed in bar. 1 bar equals to 0.1 MPa.

**Example 1 : 582/39 Copolymer VDF: 70% - TrFE: 30% by moles**

In an AISI 316 steel vertical autoclave equipped with baffles, and stirrer working at 150 rpm, 56 l of demineralized water were introduced. Then the temperature was brought to reaction temperature of 85°C, when this temperature was reached, 160 ml of pure Ethyl acetate and VDF in an amount so as to reach a partial pressure of VDF of 6.9 abs bars were introduced. Next, a gaseous mixture of VDF-TrFE in a molar nominal ratio of 70/30 was added via a compressor, until reaching a total pressure of 30 bars. The composition of the gaseous mixture present in the autoclave head was analysed by G.C. At polymerization inception, the gaseous phase was found to be composed of: 75.7% moles VDF, 24.3% moles TrFE. Then 660ml of solution of sodium persulphate (NaPS) in demineralized water with a concentration of 14,4 % in weight were fed.

The polymerization pressure was maintained constant by feeding the above mentioned VDF TrFE mixture; when 20000g of the mixture have been fed, the feeding mixture was interrupted then reducing the stirring down to 50 rpm, the reactor was cooled down at room temperature and the aqueous dispersion was discharged. The polymer was then extracted by freezing the aqueous dispersion for 48 hours and then unfreezing it. Once unfrozen, the coagulated polymer was washed with demineralized water and dried at 80°C for 48 hours.

**Example 2 : 582/34 Copolymer VDF: 75% - TrFE: 25% by moles**

In an AISI 316 steel horizontal autoclave equipped with stirrer working at 90 rpm, 14.2 l of demineralized water were introduced. Then the temperature was brought to reaction temperature of 70°C, when this temperature was reached, 500 ml of a 6.6% by weight water solution of Ethyl acetate (chain transfer agent) and VDF in an amount so as to reach a partial pressure of VDF of 7.35 abs bars were introduced. Next, a gaseous mixture of VDF-TrFE in a molar nominal ratio of 75/25 was added via a compressor, until reaching a total pressure of 30 bars. The composition of the gaseous mixture present in the autoclave head was analysed by G.C. At polymerization inception, the gaseous phase was found to be composed of: 81.6% moles VDF, 18.4% moles TrFE. Then 240ml of solution of sodium persulphate (NaPS) in demineralized water with a concentration of 7.2% in weight were fed.

The polymerization pressure was maintained constant by feeding the above mentioned VDF TrFE mixture; when 3900g of the mixture have been fed, the feeding mixture was interrupted then reducing the stirring down to 15 rpm, the reactor was cooled down at room temperature and the aqueous dispersion was discharged. The polymer was then extracted by freezing the aqueous dispersion for 48 hours and then unfreezing it. Once unfrozen, the coagulated polymer was washed with demineralized water and dried at 80°C for 48 hours.

**Example 3 : 582/77 Copolymer VDF: 80% - TrFE: 20% by moles**

In an AISI 316 steel vertical autoclave equipped with baffles, and stirrer working at 500 rpm, 3.4 l of demineralized water were introduced. Then the temperature was brought to reaction temperature of 80°C, when this temperature was reached, 200 ml of a 6.6% by weight water solution of Ethyl acetate and VDF in an amount so as to reach a partial pressure of VDF of 7.75 abs bars were introduced. Next, a gaseous mixture of VDF-TrFE in a molar nominal ratio of 80/20 was added via a compressor, until reaching a total pressure of 30 bars. The composition of the gaseous mixture present in the autoclave head was analysed by G.C. At polymerization inception, the gaseous phase was found to be composed of: 86.1 % moles VDF, 13.9% moles TrFE. Then 200ml of solution of sodium persulphate (NaPS) in demineralized water with a concentration of 7.2% in weight were fed.

The polymerization pressure was maintained constant by feeding the above mentioned VDF TrFE mixture; when 1000g of the mixture have been fed, the feeding mixture was interrupted then reducing the stirring down to 50 rpm, the

reactor was cooled down at room temperature and the aqueous dispersion was discharged. The polymer was then extracted by freezing the aqueous dispersion for 48 hours and then unfreezing it. Once unfrozen, the coagulated polymer was washed with demineralized water and dried at 80°C for 48 hours.

**Emulsion polymerization examples in the presence of cyclic surfactant of formula (V) wherein $X_a$ = $NH_4$ and radical initiator (comparative examples)**

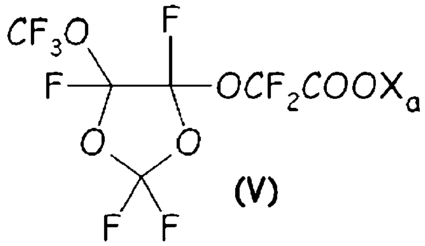

**(V)**

Example CA1 - Copolymer VDF-TrFE 70/30 (molar ratio)

In an AISI 316 steel vertical autoclave equipped with baffles, and stirrer working at 570 rpm, 3.5 l of demineralized water were introduced. Then the temperature was brought to reaction temperature of 85°C; once this reached, 50 g of a solution at 34% wt/wt of cyclic surfactant of formula (V), as above detailed, with $X_a$ = $NH_4$, in distilled water, and VDF in an amount so as to reach a partial pressure of VDF of 6.9 abs bars were introduced. Next, a gaseous mixture of VDF-TrFE in a molar nominal ratio of 70/30 was added via a compressor, until reaching a total pressure of 30 bars. The composition of the gaseous mixture present in the autoclave head was analysed by G.C. At polymerization inception, the gaseous phase was found to be composed of: 75.9% moles VDF, 24.1% moles TrFE. Then, 50ml of solution of sodium persulphate (NaPS) in demineralized water at a concentration of 3% in volume were fed. The polymerization pressure was maintained constant by feeding the above mentioned VDF-TrFE mixture; when 500g of the mixture were fed, the feeding mixture was interrupted and while keeping constant the reaction temperature, the pressure was left to fall down to 15 abs bars. Then the reactor was cooled at room temperature, the latex was discharged. The polymer was then extracted by freezing the latex for 48 hours and then unfreezing it. Once unfrozen, the coagulated polymer was washed with demineralized water and dried at 80°C for 48 hours.

Example CA2 -- Copolymer VDF-TrFE 75/25 (molar ratio)

Same procedure as in Ex. CA1 was followed, but introducing first 7.35 abs bars of VDF and supplementing with a gaseous mixture of VDF-TrFE in a molar nominal ratio of 75/25 until reaching a set point total pressure of 30 bars, and continuing feeding of the said mixture for maintaining set-point pressure.

Example CA3 -- Copolymer VDF-TrFE 80/20 (molar ratio)

Same procedure as in Ex. CA1 was followed, but introducing first 7.8 absolute bars of VDF and supplementing with a gaseous mixture of VDF-TrFE in a molar nominal ratio of 80/20until reaching a set point total pressure of 30 abs bars, providing for overall initial composition: 81.9% moles VDF, 18.1% moles TrFE, and continuing feeding of the said mixture for maintaining set-point pressure.

**Emulsion polymerization examples in the presence of PFPE surfactant and inorganic initiator (comparative)**

**Example CB1** -- Copolymer VDF-TrFE 70/30 (molar ratio)

In an AISI 316 steel vertical autoclave equipped with baffles, and stirrer working at 570 rpm, 3.5l of demineralized water was introduced. The temperature was raised to reaction temperature of 85°C, and once reached, 32.5 g of a micro-emulsion A prepared according to EXAMPLE 1 of US 7122608 (SOLVAY SOLEXIS S.P.A.), were introduced.

The micro-emulsion A was prepared as follows:
In a glass reactor equipped with stirrer, under mild stirring, 4.83 g of NaOH were dissolved in 32.83 g of demineralized water. The obtained solution was added with:

- 52.35 g of $CF_3O(CF_2-CF(CF_3)O)_{m'}(CF_2O)_{n'}-CF_2COOH$
  wherein m'/n'=20 and having number average molecular weight 434, free from fractions having molecular weight higher than 700 and containing 9% by weight of fractions having molecular weight comprised between 600 and 700, and
- 10 g of Galden[(R)] having formula $CF_3O(CF_2-CF(CF_3)O)_{m'}(CF_2O)_{n'}-CF_3$
  wherein m'/n'=20, having number average molecular weight of 760.

Then 6.95 absolute bars of vinylidene fluoride were introduced. A gaseous mixture of VDF-TrFE in a molar nominal ratio of 70/30 was added through a compressor until reaching set-point pressure of 30 abs bars. The gaseous phase was found by GC to be made of: 76.3% moles VDF, 23.7% moles TrFE. Then through a metering system, 60 ml of an aqueous solution (1 % wt) of ammonium persulphate was introduced. The polymerization pressure was maintained constant by feeding the above mentioned monomeric mixture; when 2% of the mixture (on targeted 288 g) were fed, the temperature was lowered to 105°C. Once 288g of the mixture were fed, feeding was interrupted and while keeping constant temperature, the pressure was left to fall down to 15 abs bars. The reactor was cooled at room temperature, the latex was discharged. The polymer was then extracted by freezing the latex for 48 hours and then unfreezing it. Once unfrozen, the coagulated polymer was washed with demineralized water and dried at 80°C for 48 hours.

**Example CB2** -- Copolymer VDF-TrFE 75/25 (molar ratio)

Same procedure as in Ex. CB1 was followed, but introducing first 7.35 absolute bars of VDF and supplementing with a gaseous mixture of VDF-TrFE in a molar nominal ratio of 75/25 until reaching a set point total pressure of 30 abs bars, providing for overall initial composition: 82.2% moles VDF, 17.8% moles TrFE, and continuing feeding of the said mixture for maintaining set-point pressure.

**Example CB3** -- Copolymer VDF-TrFE 80/20 (molar ratio)

Same procedure as in Ex. CB1 was followed, but introducing first 7.8 absolute bars of VDF and supplementing with a gaseous mixture of VDF-TrFE in a molar nominal ratio of 80/20 until reaching a set point total pressure of 30 abs bars, providing for overall initial composition: 81.7% moles VDF, 18.3% moles TrFE, and continuing feeding of the said mixture for maintaining set-point pressure.

Table 1 reported below includes a summary of the main physical and thermodynamic properties of the dispersion and Polymer obtained from the examples.

In Table 1 $T_c$, $\Delta H_c$, $T_m$ and $\Delta H_m$ are, respectively, the Curie transition temperature, the enthalpy associated to the Curie transition, the melting temperature and the enthalpy of melting, of the polymer as determined by differential scanning calorimetry according to ASTM D3418 and ASTM D3418.

$X_c$ is the parameter:

$$Xc\,(\%) = \frac{\Delta H_c}{(\Delta H_m + \Delta H_c)} \times 100$$

Mw is the weight averaged molecular weight of the polymer, as determined by GPC against polystyrene standards, using dimethylacetamide as solvent.

Particle size is the number average particle size (in nm) of the polymer particles within the aqueous dispersion as discharged from the reactor at the end of the polymerization process, measured with laser scattering in accordance with ISO 13321. Dry content is the % in weight of polymer contained in the aqueous dispersion as discharged from the reactor at the end of the polymerization process.

Table 1

| Run | $T_c$ | $\Delta H_c$ (J/g) | $T_m$ | $\Delta H_m$ (J/g) | $X_c$ (%) | Particle size (nm) | Dry content |
|---|---|---|---|---|---|---|---|
| Ex. 1 | 102°C | 22,40 | 146°C | 25,68 | 46,7 | 650 | 23 |
| Ex. 2 | 116°C | 28,7 | 147°C | 25,50 | 53,1 | 650 | 22 |
| Ex. 3 | 136°C | 35,74 | 146°C | 19,19 | 65,1 | 650 | 23 |
| Ex CA1 | 102°C | 21,46 | 147°C | 25,09 | 42,0 | 230 | 13 |
| Ex CA2 | 116°C | 26,01 | 147°C | 26,54 | 49,5 | 230 | 13 |

(continued)

| Run | $T_c$ | $\Delta H_c$ (J/g) | $T_m$ | $\Delta H_m$ (J/g) | $X_c$ (%) | Particle size (nm) | Dry content |
|---|---|---|---|---|---|---|---|
| Ex CA3 | 132°C | 32,67 | 145°C | 20,97 | 60,9 | 230 | 13 |
| Ex CB1 | 96°C | 15,75 | 143°C | 22,91 | 40,7 | 270 | 13 |
| Ex CB2 | 110°C | 21,68 | 143°C | 25,61 | 45,8 | 270 | 13 |
| Ex CB3 | 131°C | 28,47 | 145°C | 26,28 | 52,0 | 270 | 13 |

Now referencing the graph of Fig. 1, which reports a plot of the parameter Xc (%), as a function of the content of VDF (in % moles) for polymer (F) using the data of Table 1, it can be seen that polymers F made in accordance to the present invention all have a higher Xc value than polymers having the same amount of VDF and made with the prior art methods.

This higher level of Xc reflects in improved electrical properties as it can be seen from the data reported in Table 2. The data reported in table have been measured on films made from the polymers obtained in the examples (as detailed below in the test methods section). Comparing polymers having the same content in VDF as % moles (Ex. 1 according to the invention directly compares with comparative examples Ex CA1 and Ex CB 1, Ex. 2 according to the invention directly compares with comparative examples Ex CA 2 and Ex CB 2, and so on for examples 3) it can be see that polymers according to the invention have improved properties for all electrical properties reported.

**Table 2 electrical performance data**

| | LC | $P_r$ | $P_{max}$ | d33 | Ec | MPV | BKD |
|---|---|---|---|---|---|---|---|
| Ex. 1 | 3.5 | 8.8 | 9.9 | 22.1 | 46 | 250 | 275 |
| Ex. 2 | 7.4 | 9.5 | 10.7 | 23.4 | 45 | 250 | 275 |
| Ex. 3 | 0.012 | 10.6 | 11.4 | 27.6 | 44 | 250 | 275 |
| Ex CA1 | 15 | 6.7 | 8.7 | 20.7 | 56 | 175 | 200 |
| Ex CA2 | 54 | 7.4 | 9.1 | 21.1 | 54 | 175 | 200 |
| Ex CA3 | 0.62 | 7.5 | 9.5 | 25.9 | 55 | 200 | 225 |
| Ex CB1 | 34 | 6.2 | 7.9 | 20.2 | 76 | 150 | 180 |
| Ex CB2 | 67 | 5.8 | 7.4 | 17.2 | 78 | 150 | 180 |
| Ex CB3 | 690 | 5.6 | 7.2 | 16.9 | 74 | 150 | 180 |

Wherein

- LC = Leakage Current in $Ax10^{-9}$ with 10 V/$\mu$m
- $P_r$ = Residual Polarization in $\mu C/cm^2$
- $P_{max}$ = Maximum Polarization in $\mu C/cm^2$
- d33 = Piezoelectric Coefficient in $\mu$C/N
- Ec = Coercive Field in V/$\mu$m
- MPV = Maximum Poling Voltage
- BKD = Breakdown Voltage in V/$\mu$m

Test methods:

Determination of thermal properties

(j) Determination of Curie transition temperature ($T_C$) and enthalpy associated to the Curie transition ($\Delta H_c$).

The $T_c$ or Curie transition temperature represents the temperature at which the transition between ferroelectric and paraelectric phase occurs in a ferroelectric material. It is determined as the first endothermic peak appearing in the DSC thermogram during the second heating cycle, otherwise realised pursuant to the ASTM D 3418 standard. The $\Delta H_c$ is the enthalpy associated to this first order transition (Curie transition), as determined in the second heating cycle of the DSC thermogram, as above detailed, applying, *mutatis mutandis*, indications contained in ASTM D 3418 standard to the first

endothermic peak appearing in said second heating cycle. The DSC analyses were performed using a Perkin Elmer Diamond DSC instrument, adopting a ramp rate of 10°C/min in second heating cycle, as prescribed in ASTM D 1238.

(jj) Determination of enthalpy of melting ($\Delta H_m$) and melting temperature ($T_m$)

The enthalpy of melting ($\Delta H_m$) and melting temperature ($T_m$) are determined by differential scanning calorimetry (DSC), pursuant to ASTM D 3418, using a Perkin Elmer Diamond DSC instrument.

**Determination of piezoelectric properties**

**(i) Preparation of films**

Solutions in methylethylketone having concentration of 20 % w/w of the polymers were prepared, and films casted by doctor blade technique, using an Elcometer automatic film applicator, model 4380, onto a glass substrate.

The polymer layers so casted were dried at 100°C for 2 hours under vacuum. On so obtained dried films, by inkjet printing technique, 12 patterns of 1 cm x 1 cm were printed as electrodes on both sides of the polymeric film using as conductive material a poly(3,4-ethylenedioxythiophene) polystyrene sulfonate (PEDOT:PSS) purchased by Agfa-Gevaert under the trademark name ORGACON®. The thickness of the samples was measured using a Mitutoyo micrometer.

**(ii) Annealing of films**

The films obtained as above detailed were placed in a vented oven set at an inner temperature 135°C. After one hour the oven was switched off and cooled for 5 hours, until reaching room temperature.

**(iii) Poling of films**

A LC Precision poling equipment combined with a High Volate Interface with 10KV maximum field generated, by RADIANT was used for poling the films. The annealed films were placed in the polarization cell where field of 150 V/microns or 200 V/microns was applied trough the annealed film specimens.

**(iv) Determination of piezoelectric coefficient (d33)**

The value of the piezoelectric coefficient (d33) was measured using a PIEZOMETER PM300 instrument, placing the poled sample obtained as described above in the instrument strain gouge where the film was stimulated under a vibration at 110 Hz at room temperature. The d33 is reported as μC/N.

**(v) determination of leakage current at 100 V/μm**

Leakage current refers to a gradual loss of energy from a charged capacitor. Determination of leakage current is performed in the polarization cell applying 100 V/microns on the electrodes of the capacitor and determining the said loss in energy after 5 seconds.

**(vi) determination of dielectric permittivity of the films**

The value of dielectric permittivity [k] was derived from the direct measurement of dielectric capacitance by a piezo meter system provided by Piezotest. The capacitance values were all measured at 110 Hz.

$$\text{Dielectric permittivity [k]} = \frac{\text{Capacitance [F] x Thickness [m]}}{\varepsilon_0 \text{ [F/m] x Area [m}^2\text{]}}$$

**(vii) ferroelectric hysteresis measurements ($P_r$, $P_{max}$)**

The hysteresis determination was performed by submitting the annealed film to poling in a field from 80 V/microns to 250 V/microns, obtaining an hysteresis curve were the maximum polarization, and residual polarization were measured. The $P_{max}$ is the maximum polarization achievable with the maximum field applied, the $P_r$ is the residual polarization (also referred to as remnant polarization) in the samples after the removal of the applied field.

**(viii) Coercive field (Ec).**

The coercive field is the minimum voltage that is needed to start orienting the dipoles in a polymeric film and is extrapolated form the hysteresis loop as Ec , where the polarization is equal to 0.

**(ix) Breakdown voltage and maximum poling field ( BKD and MPV)**

The breakdown voltage (BKD) is the minimum voltage that causes a portion of an insulator to become electrically conductive generating its failure when poling process is applied. The maximum poling voltage (MPV) is the maximum voltage applied to the polymer specimen, usually kept 10-15% for copolymer and 20-25% for terpolymers lower than the BKD as a safety margin for testing and where polarization values are no more improved by electrical field.

## Claims

1. A method for making an aqueous dispersion of polymer particles of a fluoropolymer (polymer F) said polymer F comprising:

   - recurring units derived from vinylidene fluoride (VDF) in an amount of from 60% to 82% in moles, with respect to the total moles of recurring units
   - recurring units derived from trifluoroethylene (TrFE) in an amount of from 18% to 40% in moles, with respect to the total moles of recurring units, and
   - optionally recurring units derived from at least one additional monomer different from VDF and TrFE,
   - said particles having a number average particle size measured with laser scattering method in accordance with ISO 13321 comprised from 200 to 5000 nm,

   said polymer F possessing a thermodynamic ordered structure in the ferroelectric phase, such that the relation between:

   (i) the parameter Xc (%)defined as follows:

$$Xc\ (\%) = \frac{\Delta H_c}{(\Delta H_m + \Delta H_c)} \times 100$$

   wherein $\Delta H_c$ is the enthalpy associated to the Curie transition between ferroelectric and paraeletric phase, as determined in J/g by DSC technique on second heating scan, at a ramp rate of 10°C, and $\Delta H_m$ is the enthalpy of melting, as determined in J/g according to ASTM D3418; and
   (ii) the content in recurring units of VDF expressed in % moles, with respect to the total moles of recurring units, designated as CM, satisfies the following inequality:

$$Xc(\%) > a*(100-CM) + b$$

   wherein a= -1,89, b=99, said method comprising polymerizing 60% to 82% in moles based on the total moles of monomers of vinylidene fluoride (VDF), 18% to 40% in moles based on the total moles of monomers of trifluoroethylene (TrFE), and optionally at least one additional monomer different from VDF and TrFE in an aqueous reaction medium in the presence of a radical initiator selected from the group consisting of persulfates, preferably selected from sodium, potassium or ammonium persulfates, wherein:

   - the polymerization is conducted at a total pressure comprised between 25 and 35 bars (2.5 to 3.5 MPa) and a temperature comprised between 75°C and 95°C,
   - the dispersion obtained has a solid content of 1 to 30% by weight,
   - the aqueous reaction medium is free from fluorinated surfactants.

2. A method according to claim 1 wherein the aqueous reaction medium is free from added surfactants.

3. A method according to claims 1 or 2 wherein the number average particle size of the polymer particles measured with

laser scattering method in accordance with ISO 13321 is comprised from 200 to 5000 nm.

**4.** A method according to claims 1-3 wherein the polymerization is conducted at a total pressure comprised between 27 and 32 bars (2.7 to 3.2 MPa) and a temperature comprised between 82°C and 90°C,

**5.** A method according to claims 1-4 wherein the aqueous dispersion has a solid content of from 10% to 30% by weight, preferably from 15% to 30% by weight.

**Patentansprüche**

**1.** Verfahren zur Herstellung einer wässrigen Dispersion von Polymerpartikeln eines Fluorpolymers (Polymer F), wobei das Polymer F umfasst:

- von Vinylidenfluorid (VDF) abgeleitete Wiederholungseinheiten in einer Menge von 60 Mol-% bis 82 Mol-%, bezogen auf die Gesamtmolzahl an Wiederholungseinheiten,
- von Trifluorethylen (TrFE) abgeleitete Wiederholungseinheiten in einer Menge von 18 Mol-% bis 40 Mol-%, bezogen auf die Gesamtmolzahl an Wiederholungseinheiten, und
- gegebenenfalls Wiederholungseinheiten, die von wenigstens einem zusätzlichen Monomer, das von VDF und TrFE verschieden ist, abgeleitet sind,
- wobei die Partikel eine anzahlgemittelte Partikelgröße, gemessen durch Laserstreuverfahren nach ISO 13321, in dem Bereich von 200 bis 5000 nm aufweisen, wobei das Polymer F eine thermodynamische geordnete Struktur in der ferroelektrischen Phase aufweist, so dass die Beziehung zwischen:

(i) dem Parameter Xc (%), definiert wie folgt:

$$Xc\ (\%) = \frac{\Delta H_c}{\Delta H_m + \Delta H_c}\ x\ 100$$

wobei $\Delta H_c$ die Enthalpie ist, die mit dem Curie-Übergang zwischen ferroelektrischer und paraeletrischer Phase verbunden ist, wie in J/g durch DSC-Verfahren bei dem zweiten Heizdurchlauf mit einer Rampenrate von 10 °C bestimmt, und $\Delta H_m$ die Schmelzenthalpie ist, wie in J/g nach ASTM D3418 bestimmt; und
(ii) dem Gehalt an Wiederholungseinheiten von VDF, ausgedrückt in Mol-%, bezogen auf die Gesamtmolzahl an Wiederholungseinheiten, bezeichnet als CM, die folgende Ungleichung erfüllt:

$$Xc\ (\%) > a*(100-CM) + b$$

wobei a =-1,89, b=99, wobei das Verfahren Polymerisieren von 60 Mol-% bis 82 Mol-%, bezogen auf die Gesamtmolzahl, an Monomeren von Vinylidenfluorid (VDF), 18 Mol-% bis 40 Mol-%, bezogen auf die Gesamtmolzahl, an Monomeren von Trifluorethylen (TrFE) und gegebenenfalls wenigstens eines zusätzlichen Monomers, das von VDF und TrFE verschieden ist, in einem wässrigen Reaktionsmedium in Gegenwart eines Radikalinitiators ausgewählt aus der Gruppe bestehend aus Pernatriumsulfaten, vorzugsweise ausgewählt aus Natrium-, Kalium- und Ammoniumpersulfaten, umfasst, wobei:

- die Polymerisation bei einem Gesamtdruck in dem Bereich zwischen 25 und 35 bar (2,5 bis 3,5 MPa) und einer Temperatur in dem Bereich zwischen 75 °C und 95 °C durchgeführt wird,
- die erhaltene Dispersion einen Feststoffgehalt von 1 bis 30 Gew.-% aufweist,
- das wässrige Reaktionsmedium frei von fluorierten Tensiden ist.

**2.** Verfahren nach Anspruch 1, wobei das wässrige Reaktionsmedium frei von zugesetzten Tensiden ist.

**3.** Verfahren nach Anspruch 1 oder 2, wobei die anzahlgemittelte Partikelgröße der Polymerpartikel, gemessen durch Laserstreuverfahren nach ISO 13321, in dem Bereich von 200 bis 5000 nm liegt.

**4.** Verfahren nach Ansprüchen 1-3, wobei die Polymerisation bei einem Gesamtdruck in dem Bereich zwischen 27 und 32 bar (2,7 bis 3,2 MPa) und einer Temperatur in dem Bereich zwischen 82 °C und 90 °C durchgeführt wird.

5. Verfahren nach Ansprüchen 1-4, wobei die wässrige Dispersion einen Feststoffgehalt von 10 Gew.-% bis 30 Gew.-%, vorzugsweise von 15 Gew.-% bis 30 Gew.-%, aufweist.

## Revendications

1. Procédé de préparation d'une dispersion aqueuse de particules de polymère d'un fluoropolymère (polymère F), ledit polymère F comprenant :

   - des motifs répétitifs issus du fluorure de vinylidène (VDF) en une quantité de 60 % à 82 % en moles par rapport aux moles totales de motifs répétitifs
   - des motifs répétitifs du trifluoroéthylène (TrFE) en une quantité de 18 % à 40 % en moles par rapport aux moles totales de motifs répétitifs, et
   - éventuellement des motifs répétitifs issus d'au moins un monomère supplémentaire différent du VDF et du TrFE,
   - lesdites particules ayant une taille moyenne de particule en nombre mesurée par un procédé de diffraction laser conformément à la norme ISO 13321 comprise entre 200 à 5 000 nm,

   ledit polymère F possédant une structure ordonnée thermodynamique dans la phase ferroélectrique, telle que la relation entre :

   (i) le paramètre Xc (%) défini comme suit :

$$Xc\ (\%) = \frac{\Delta H_c}{\Delta H_m + \Delta H_c}\ x\ 100$$

   dans lequel $\Delta H_c$ est l'enthalpie associée à la transition de Curie entre la phase ferroélectrique et paraélectrique, telle que déterminée en J/g par la technique DSC sur le deuxième balayage de chauffage, à une vitesse de rampe de 10 °C, et $\Delta H_m$ est l'enthalpie de fusion, telle que déterminée en J/g selon la norme ASTM D3418 ; et
   (ii) la teneur en motifs répétitifs de VDF, exprimée en % moles, par rapport aux moles totales de motifs répétitifs, désignées comme CM, satisfait à l'inégalité suivante :

$$Xc(\%) > a*(100-CM) + b$$

   dans laquelle a = -1,89, b = 99, ledit procédé comprenant la polymérisation de 60 % à 82 % en moles sur la base des moles totales de monomères de fluorure de vinylidène (VDF), 18 % à 40 % en moles sur la base des moles totales de monomères de trifluoroéthylène (TrFE), et éventuellement au moins un monomère supplémentaire différent du VDF et du TrFE dans un milieu réactionnel aqueux en présence d'un initiateur de radicaux choisi dans le groupe constitué par les persulfates, préférentiellement choisis parmi les persulfates de sodium, de potassium ou d'ammonium, dans lequel :

   - la polymérisation est réalisée à une pression totale comprise entre 25 et 35 bars (2,5 à 3,5 MPa) et une température comprise entre 75 °C et 95 °C,
   - la dispersion obtenue a une teneur en solides de 1 à 30 % en poids,
   - le milieu réactionnel aqueux est exempt de tensioactifs fluorés.

2. Procédé selon la revendication 1, dans lequel le milieu réactionnel aqueux est exempt de tensioactifs ajoutés.

3. Procédé selon la revendication 1 ou 2, dans lequel la taille moyenne de particule en nombre de polymère mesurée par un procédé de diffraction laser conformément à la norme ISO 13321 est comprise entre 200 et 5 000 nm.

4. Procédé selon les revendications 1-3, dans lequel la polymérisation est réalisée à une pression totale comprise entre 27 et 32 bars (2,7 à 3,2 MPa) et une température comprise entre 82 °C et 90 °C,

5. Procédé selon les revendications 1-4, dans lequel la dispersion aqueuse a une teneur en solides de 10 % à 30 % en poids, de préférence de 15 % à 30 % en poids.

Figure 1

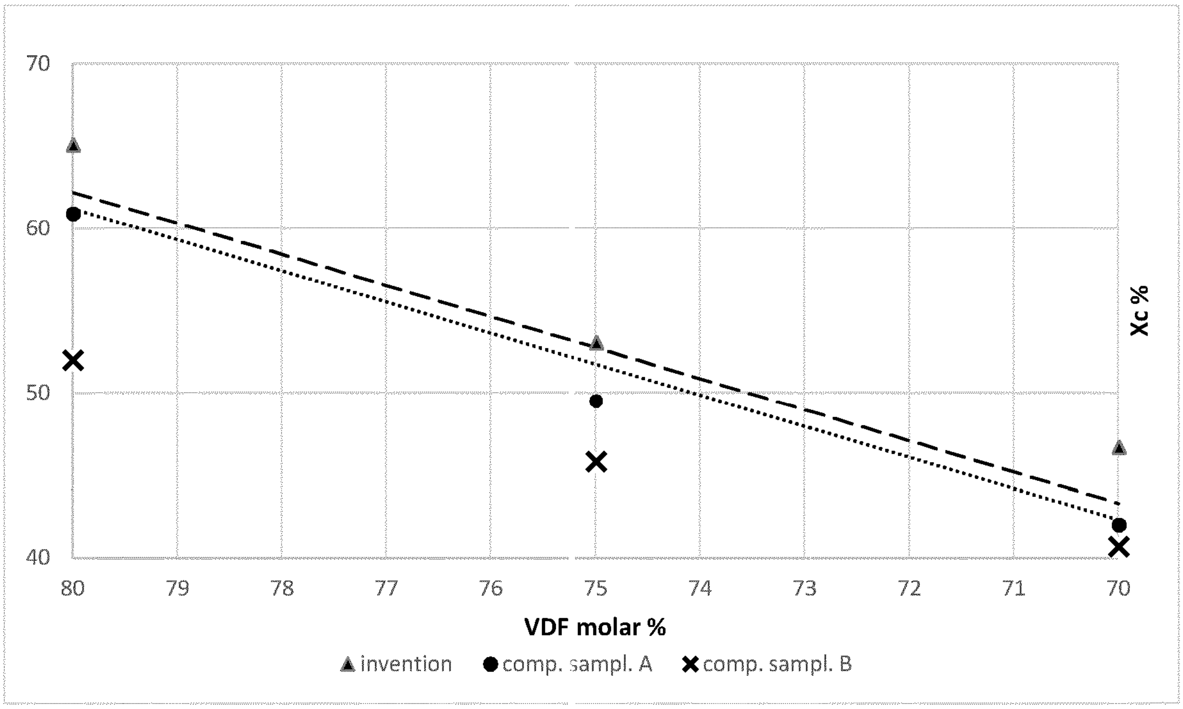

70
60
50
40
80
79
78
77
76
75
74
73
72
71
70
Xc %
VDF molar %
invention
comp. sampl. A
comp. sampl. B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4778867 A, PRIES SEYMOUR
- US 4708989 A, THOMSON CSF
- US 4784915 A, KUREHA CHEMICAL IND CO LTD
- US 4173033 A, DAIKIN IND LTD
- WO 2018065306 A
- US 4611260 A, DEUTSCH FRANZ FORSCH INST
- US 4684337 A, DEUTSCH FRANZ FORSCH INST
- US 7122608 B, SOLVAY SOLEXIS S.P.A


### Non-patent literature cited in the description


- **ISNER-BROM, P. et al.** Intrinsic Piezoelectric Characterization of PVDF copolymers: determination of elastic constants. *Ferroelectrics.*, 1995, vol. 171, 271-279
- **BAUER, F. et al.** Very high pressure behaviour of precisely-poled PVDF. *Ferroelectrics*, 1995, vol. 171, 95-102